Europäisches Patentamt

European Patent Office

Office européen des brevets

(11) Publication number: **0 297 922 B1**

# EUROPEAN PATENT SPECIFICATION

(45) Date of publication of patent specification: **26.01.94**  (51) Int. Cl.⁵: **G01R 33/12**

(21) Application number: **88306053.5**

(22) Date of filing: **01.07.88**

(54) **Non-destructive method for magnetic measurements of recording disc members.**

(30) Priority: **02.07.87 US 69184**

(43) Date of publication of application:
**04.01.89 Bulletin 89/01**

(45) Publication of the grant of the patent:
**26.01.94 Bulletin 94/04**

(84) Designated Contracting States:
**AT BE CH DE ES FR GB GR IT LI LU NL SE**

(56) References cited:
**FR-A- 2 561 427
GB-A- 1 267 434
US-A- 3 697 866
US-A- 3 812 529
US-A- 3 984 763**

**IEEE TRANSACTIONS ON MAGNETICS. vol. 18, no. 6, November 1982, NEW YORK US pages 1146 - 1148; F.J.Jeffers et.al.: "Metal-in-gap record head"**

(73) Proprietor: **SEAGATE TECHNOLOGY, INC.
920 Disc Drive
Scotts Valley, California 95066(US)**

(72) Inventor: **Fisher, Robert Dwight
4452 George Oaks Drive
San Jose California 95118(US)**
Inventor: **Pressesky, Jason Lawson
1039 Greenwood Drive
Menlo Park California 94025(US)**

(74) Representative: **Bayliss, Geoffrey Cyril et al
BOULT, WADE & TENNANT
27 Furnival Street
London EC4A 1PO (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention is directed to the field of non-destructive testing of magnetic media for use in disc drives, and more particularly measurement of coercive force and remanence-thickness product as a function of circumference and/or radius of the recording member. The data can be used to adjust process parameters in manufacturing magnetic recording members.

The recording performance of a magnetic recording member is primarily determined by the magnetic properties, specifically the coercive force, remanence, and thickness of the recording member. These magnetic properties determine the signal amplitude, frequency response, resolution, and overwrite characteristics of recording disc members.

Currently, there are two common methods for measuring these properties, a vibrating sample magnetometer and a hysteresis tester. The former measures the magnetization as a function of the applied field, whereas the latter measures the flux density as a function of field. In order to obtain the fundamental magnetic properties using this equipment, namely, the coercive force, remanence, or remanence-thickness product, as well as the saturation magnetization, it is necessary to cut or define a finite element from the recording member for measurement purposes. Consequently, both techniques are destructive. In addition, both techniques or measurement methods determine the average value of the coercive force, and/or the remanence of the sample, or the finite element which was removed from the recording member for evaluation rather than the values for a specific location(s) on the surface of the member. In addition, such methods are not practical for thin film media typically utilized in advanced digital recording systems due to inadequate magnetic volume.

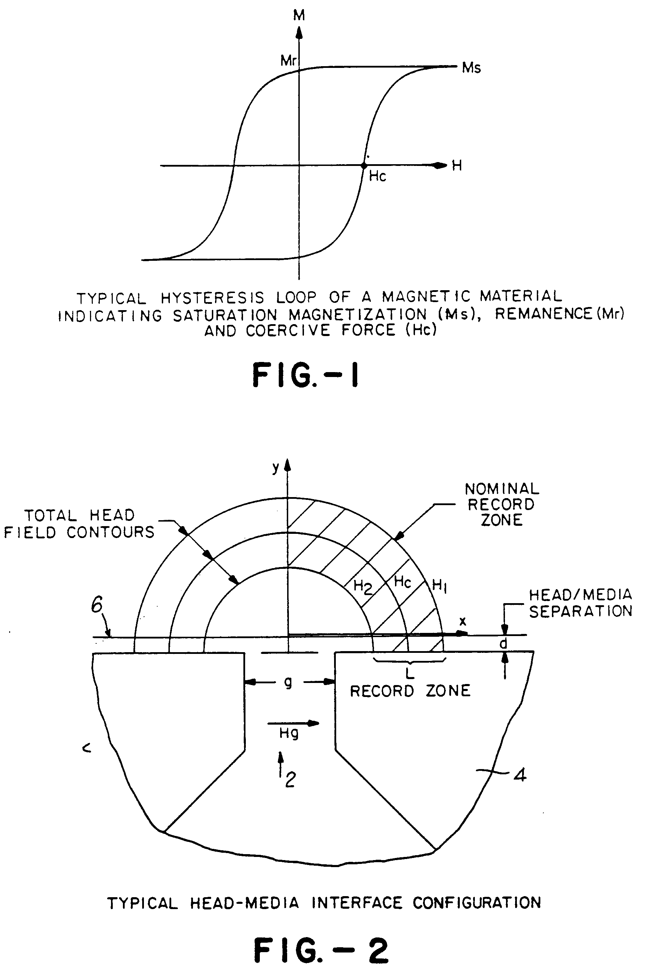

A typical hysteresis loop or B-H loop is shown in FIG 1, which describes the typical hysteresis characteristics required for evaluation of a sample. Typical digital recording media consists of magnetic oxide (gamma iron oxide) dispersed in a non-magnetic organic binder.

Thin film media are known to exhibit superior recording performance relative to particulate oxide media as a result of inherent higher remanence and coercive force values. However, the magnetic properties of oxide and thin film media are determined to a large degree by the quality of the particulate dispersion, degree of orientation of the oxide particulate particles, and the particle size. The magnetic properties of thin film media are determined by the deposition process parameters, e.g., in the case of sputtered films, process temperature and substrate type are of particular significance, as well as the sputtering pressure. Consequently, the magnetic properties of a recording member are determined in situ or after the fact. Currently, manufacturing must rely on the recording performance to monitor progress and/or adjust process parameters to conform to recording specifications.

Therefore, a need exists for a method of quickly determining the magnetic properties, particularly coercive force and the remanence-thickness product, in a non-destructive manner.

US Patent 3984763 (Koester) discloses a mechanism for non-destructive measurement of remanent flux density in magnetic recording media. Such measurements are made, according to this document, using spaced-apart read heads and write heads, one read and one write head being disposed equidistant on each side of the magnetic disc under test. The recording head pair preferably produces magnetization in each of the magnetic fields in the magnetic layer that extend parallel with the plane of the recording medium, and have the same direction. Preferably the write current frequency (25 to 300 Hz) matches the rate at which the recording medium moves, such that the distance of the recording and playback heads from the medium surfaces is between 1/5 and 1/40 the wavelength of the specific signals recorded. The signal so recorded is then read by the read heads. It is stated that US3984763 minimizes measurement sensitivity to thickness of the media substrate.

US Patent 3812529 (Yoichi) discloses a system for determining optimum recording bias level and high frequency characteristics of a magnetic tape. US 3812529 utilizes an erase head, a record head, a partial erase head and a read or reproducing head to arrive at its determinations. A constant frequency, typically 50 Hz, discrimination signal with a predetermined record bias is recorded on the tape, whereupon a partial erasure of the discrimination signal occurs. The residual or partially erased discrimination signal is then read and signal processed.

By contrast to US 3984763 and US 3812529, the present invention functions with a single head, capable of reading and writing, disposed on a single side of the magnetic medium. Further, in contrast to the relatively low frequencies employed in US 3984763 and US 3812529, the present invention writes a relatively high frequency signal (e.g., perhaps 500 KHz) to various portions of the disk under test. The present invention then applies a DC erase current, whereupon the resultant signal is measured to determine coercive force. According to the present invention, the remanence-thickness product is determined by an isolated half pulse width.

The present invention provides a method of measuring coercivity in a magnetic storage disc medium, for use with a magnetic storage device including a rotatable magnetic storage disc medium having a plurality of data recording tracks thereon to define data recording locations, and a read/write head selectively positionable over said data recording locations, said measuring method comprising the steps of recording signals in a plurality of said data recording locations on said disc, applying a DC erase field sufficient to erase the recorded signal at one of said recording locations by 50% (6 db) relative to an unerased state of said recorded signal, measuring the magnitude of the DC erase field required to reduce the recorded signal at said one recording location by said 50% (6 db), and calculating the coercivity of the disc according to the magnitude of the DC erase field required to produce said 50% (6 db) reduction in said recorded signal.

The present invention also provides a system for determining magnetic characteristics of a magnetic medium member at various known coordinate positions of the medium comprising means for applying a write current through a gap of a recording head for recording a sequence of isolated magnetic transitions at said known coordinate positions, a means for applying a DC erase field by sourcing an amount of current through said head as determined by the relationship

$$Hx= \frac{0.8 \ N \ I \ a_w}{g} \ arctan \ \frac{g}{2y}$$

wherein y is the known head-medium (d) spacing, g is the known gap width, I is the measured applied current required to produce said DC erase field, N is the known number of turns on the head, and $a_w$ is a known calibration constant dependent on head geometry; a means for measuring a resulting readback signal, means for increasing the applied field by incremental amounts, and means for plotting the relationship of said signal read-back and applied field,

whereby a point representing 50% loss in signal value defines coercivity of said medium.

An advantage of this invention is to provide a method and apparatus for measuring the coercive force as well as the remanence-thickness product in a non-destructive manner.

A related advantage of this invention is to provide method and apparatus for determining the values of the above parameters at any location on the disc surface with a minimum degree of averaging or minimum spatial resolution. This provides precise measurement of the coercive force and remanence-thickness product over the disc surface, which is necessary for determination of the recording performance and manufacturing process control.

An advantage of this invention is to provide method and apparatus for measuring the coercive force and/or variations in coercive force around any recorded track or cylinder on a disc member or measurement of the coercive force at any radial position of the disc member.

A further advantageis to allow measurement of the remanence thickness product on any recorded track or cylinder and at any radial position. Consequently, the invention allows determination of the basic magnetic properties that determine the recording performance of the disc member. Additionally, repeating measurements of the coercive force and/or remanence thickness product at different radial locations provides a means of obtaining a surface map of the basic magnetic variations within a disc recording member.

These and other advantages of this invention are accomplished by writing a low frequency or long wavelength recording pattern on a disc and measuring the signal amplitude as a function of DC erase current to determine the coercive force; subsequent calculation of the isolated half pulse width allows determination of the remanence-thickness product of the disc media. The coercive force and remanence-thickness product can thus be determined as a function of track circumference and track radius, thereby obtaining or determining variation in coercive force and/or remanence-thickness product of the disc member. This data can be used to adjust the parameters of the manufacturing process to provide consistent product output.

An alternative method for measurement of the coercive force and/or isolated pulse width is to measure the area of the isolated pulse at long wave lengths, i.e., a low frequency write pattern, e.g. 500 KHz. The coercive force may then be determined by the DC erase current magnitude which decreases the area of the pulse by 50 percent, and the remanence-thickness product is determined from the isolated half pulse width.

The features and advantages of this invention will be beter understood reviewing the following detailed description given with reference to the following figures, in which:

FIG 1 is a typical hysteresis loop of a magnetic material illustrating saturation magnetization (MS), remanence (Mr) and coercive force (Hr);

FIG 2 illustrates a typical head-media interface configuration;

FIG 3 illustrates the elements of the apparatus of this invention;

FIG 4 is a block diagram of some of the electronics of this invention;

FIG 5 illustrates calibration curve for the equipment of this invention;

FIG 6 illustrates R/W head erase efficiency as a function of DC erase current at the -6dB signal value;

FIG 7 illustrates coercive force as a function of DC erase current at -6dB current level;

FIG 8 illustrates coercive force as a function of R/W head efficiency ($a_w$) multiplied by DC erase current value at -6dB signal level;

FIG 9 illustrates coercivity as a function of angle;

FIG 10 illustrates remanence-thickness product vs. angle;

FIG 11 illustrates coercivity as a function of angle.

FIG 12 is a flow chart of the manufacturing process steps controlled by the present invention.

FIG 13 is a flow chart of the measurement and computation procedures used in practicing the method of the invention.

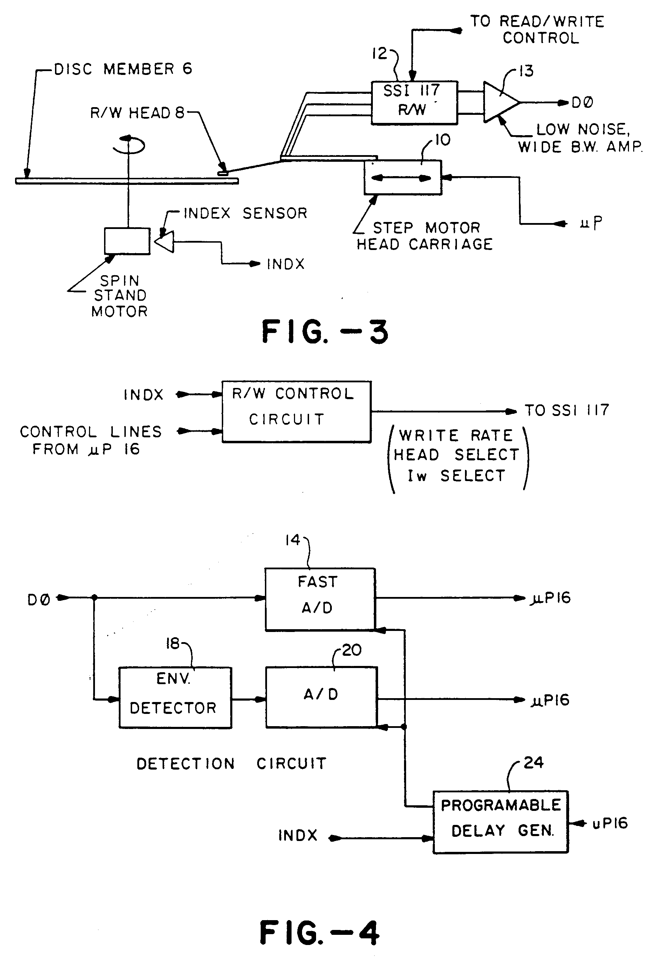

The underlying theory of this invention can be understood by the following derivation given with reference to FIG 2. As shown therein, to test the coercivity and remanence of magnetic recording media, a standardized test head 4 is used. The air gap 2 in the recording head 4 is brought into close proximity with the magnetic recording medium 6. When the head is driven by a magnetomotive force (NI), the leakage flux in the vicinity of the gap 2 saturates the thin layer of magnetizable material. Hence, when the medum moves away from the head field it retains a remanent magnetization determined by head field magnitude, the magetic characteristics of the media, and the self-demagnetization.

The head field in the vicinity of the gap can be expressed as

$$(1) \qquad H = Hg \, (g/1_a)$$

in which Hg is the homogeneous field in the gap, g is the gap length, and $1_a$ the length of the flux path in the air. As 1a is a semicircle, we can substitute $1a = \pi r$ where $r = (x^2 + y^2)$ and x, y are scalar distances as shown in FIG 2. Thus:

$$(2) \qquad H = \frac{H_g}{\pi (x^2 + y^2)^{1/2}}$$

However, this equation breaks down in the immediate vicinity of the gap because when $x = y \rightarrow O$, $H \rightarrow$ infinity. Although the geometry of the idealized head is simple, a precise analytical solution of this equation is not obtainable in closed form. An analytical approximation of the head field as a function of distance has been described by Karlquist (Trans. Royal Institute of Technology, Stockholm, Sweden, No. 86, 1954) and generally expressed as

$$(3) \qquad Hx_{x,y} = \frac{H_g}{\pi} \left[ \arctan\left(\frac{g/2 + x}{y}\right) + \arctan\left(\frac{g/2 - x}{y}\right) \right]$$

where g is the gap length, x is distance from center of gap parallel to the head face, y is the perpendicular distance from the head face (y is equivalent to the head media spacing plus 1/2 the media thickness). Consequently, the write field as a function of the coordinates x, y as shown in FIG 2 may be determined providing the homogeneous gap field (Hg) is known. The homogeneous field inside the gap may be expressed as:

$$(4) \qquad Hg = \frac{0.4 \, \pi \, N \, I \, a_w}{g}$$

If the read/write head is ferrite, it seems well established that when the deep gap record field (Hg) exceeds 1/2 of the ferrite saturation flux density (Bs/2) the gap corners start to saturate (F. Jeffers, et al., IEEE Trans. on Magnetics, Vol. Mag. 16, No. 6, p.1146, 1982). This reduces the head permeability from approximately 1000 to 50, which reduces the head efficiency $a_w$ since the head efficiency is related to the core permeability, i.e., $a_w = R_g/(R_g + R_c)$. Rc, the core reluctance is determined by the expression

$$R_c = 1/u \; \Sigma \; (1c/Ac)$$

where $A_c$ is the cross section of the core and 1c is the subsequent core length corresponding to Ac. Consequently, the recording performance at short wave lengths is drastically affected due to the reduction in permeability as well as a decrease in the head field gradient. The saturation current for a given R/W head may be determined from Equation 4 by substituting the value of Hg, gap length, efficiency and turns. Consequently, for a MnZn Ferrite head (Winchester type) with a gap of 45 microinches with 19 turns, and an efficiency of (1), the minimum saturation current may be determined as:

$$Is = \frac{2.54 \; (2500) \; 45 \times 10^{-6}}{(0.4)(3.14)(19)} = 11.9 \; milliamperes$$

Substituting for $H_g$ in Equation 3, the homogeneous field inside the gap, equation for, the recording field as a function of the distance from the gap (x,y) may now be expressed as:

$$(5) \quad Hx = \frac{0.4 \; N \; I \; a_w}{g} \left[ arctan\left(\frac{g/2 + x}{y}\right) + arctan\left(\frac{g/2 - x}{y}\right) \right]$$

Hence, it should be emphasized that the expression for determining the coercive force ($Hc = Hx_{0,y}$) is given by:

$$(6) \quad Hx_{0,y} = \frac{0.8 \; N \; I \; a_w}{g} \; arctan \; g/2y$$

However, the precise value of $a_w$ is not known especially as a function of frequency as well as the simple fact that $a_w$ is dependent on head geometry(Rc, the core reluctance). Therefore, it is necessary to determine the value of $a_w$ utilizing a media with a known coercive force value.

$$(7) \quad H_{x_{(0,y)}} = \frac{0.8 \; a_w \; N \; I \; arctan(g/2y)}{g} = Hc \; (known \; media)$$

$$a_w = \frac{g \; Hc \; (known \; media)}{0.8 \; N \; I \; arctan \; (g/2y)}$$

Consequently, the coercive force of an unknown media may be determined from Equation 6 since $a_w$ is obtained from the calibration of a standard disc. Determination of the remanence-thickness product for thin film media simply requires a measurement of the isolated pulse width which may be determined directly or by integrating the area beneath an isolated transition pulse as given by:

$$Ap = 2 \int_{T_0^s}^{T_1} \frac{Ep}{1 + (t/T_{50})^2} \, dt$$

or

$$Ap = 2Ep \, T_{50} \int_{T=0}^{T=\infty} \frac{1}{1 + (t/T_{50})T_{50}} \, dt$$

where:

T50 = half pulse width of isolated transition (time)

Ep = maximum amplitude of the isolated pulse (volts)

t = time in secs.

Consequently,

(8)    $Ap = \pi Ep \, T50$

(9)    $T50 = Pw50/Velocity$

(10)    $Pw50 = Velocity \, AP/EP\pi$

Determination of the remanent-thickness product is then calculated from the known isolated half pulse width on the following basis:

(11)    $Pw50 = [g2 + 4 (a + d)^2]^{1/2}$

(12)    $a = [4.62 \, Mr \, T \, d/Hc]^{1/2}$

where:

d = distance of separation between media and head or the flying height

g = R/W head gap length

a = transition parameter

Therefore, substituting into Equation (11) and solving for the remanence-thickness product results in the expression for MrT as a function of coercive force (Hc),isolated half pulse width ($Pw_{50}$), R/W head gap length (g), and distance of separation or flying height (d), i.e.:

$$(13) \qquad MrT = \frac{Hc \, [0.5 \, (Pw50)^2 - g^2)^{1/2} - d]^2}{4.62 \, (d)}$$

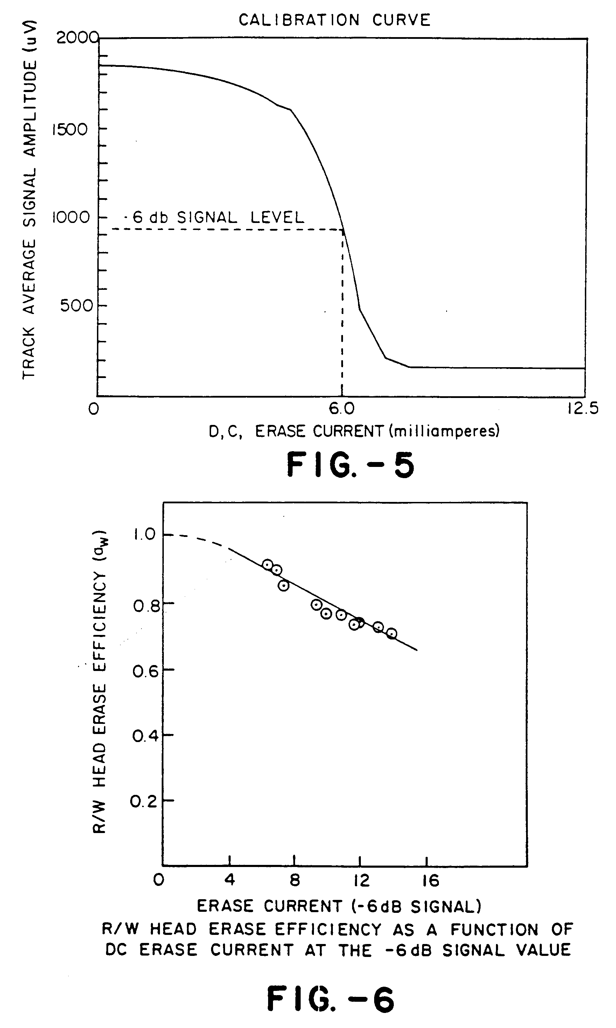

The equipment or test stand utilized for measuring the coercive force and/or remanence-thickness product is shown in FIGS 3 and 4. The equipment consists of the member to be evaluated 6; the R/W head and arm assembly 8 including head 4 which records at gap 2; R/W head positioning carrige 10 to position gap 2 to allow measurements as a function of radii; and a R/W amplifier 12, e.g., an SSI 117 chip. The output $d\phi/dt$ of the R/W amplifier 12 is coupled directly through an a/d converter 14 to a microprocessor 16. The same output is connected through a peak or envelope detector 18 to second a/d converter 20. To relate the position of the gap 2 to the data being received, a R/W control circuit 22 and programmable delay generator 24 both receive a common INDX signal. R/W control 22 controls amplifier 12 to read and record information on medium 6. Programmable delay generator 24 responds to the same INDX signal to cause the readback data from selected points on the disc to be read and stored.

In order to measure the coercive force of the disc member, the following test sequence is initiated and controlled by microprocessor 16; necessary programming is well within the skill of the state of the art and is not disclosed herein in detail. The outline of the steps to be followed appears in FIG 13.

(1) A sequence of isolated transitions (low frequeny, i.e., long wavelength) is recorded (step 50) at optimum write current around the circumference of the disc from the outside track to the inside track using head 8 and control circuit 22. This puts the tracks of disc 6 in a state of magnetization where there are an equal number of magnetic regions facing in positive and negative directions (transitions). The transitions are spaced widely enough so that they do not interfere with each other due to the low frequency write. A signal ($d\phi/dt$) is induced in the head 8 by the magnetic transitions as the transitions move past the head. The amplitude of this signal is digitized at converter 14 and stored 52 as a value (Ep) by microprocessor 16.

(2) A DC erase field is applied 54 by sourcing a small amount of current through the recording head 8 (the magniude of this field is determined by Eq. 6).

(3) The amplitude of the readback signal is again measured and stored 56.

(4) The DC erase field applied through amplifier 12 and head 8 is incremented 58 by a small amount, and steps 2 and 3 are repeated. An alternative method is that the DC erase field applied through amplifier 12 and head 8 be incremented only after rewriting with optimum write current step 1. Steps 2, 3 and 4 are repeated until the signal has decreased to essentially zero signal level and the signal amplitude is plotted as a function of the write field erase magnitude and/or write erase current.

(5) The coercivity of the disc is defined as the magniude of the DC erase field at a 50% loss in signal value, i.e., the -6dB signal level versus DC erase current value (DC field) 60. This is analogous or equivalent to the coercive force obtained from the hysteresis loop (M-H loop) measured on a vibrating sample magnetometer, i.e., the field required to reverse half the magnetization (see FIG 1). In the M-H loop, the coercivity is defined as the field required to take the sample from a state of saturation to a state of zero magnetization. However, in a state of zero magnetization, the material consists of a multitude of magnetic domains, of which there are an equal number in the positive and negative directions, thereby cancelling themselves and yielding a total moment of zero. In the recording situation described, only the transitions contribute to the signal, so the situation is somewhat different. Regions whose magnetization are aligned with the direction of the applied DC field (erase field) are stable, since they are saturated in that direction to begin with. The DC erase affects only those regions whose direction of magnetization is opposed to the applied DC erase field. Therefore, the field required to accomplish a 50% reduction is signal (50% switching of allowed domains) is equivalent to the coercive force.

(6) In practice, the field increments used in steps 2-4 are typically 50 Oe. To overcome this limitation of field resolution, the program follows known mathematical procedures that are well known to a person of skill in the art to perform an interpolation between the data points that bracket the 50% signal loss point. This is sufficient to give a resolution of 1.0 Oe and a precision of 3.0 Oe on a 650 Oe disc member. In order to obtain information about coercivity variations along the recorded track (azimuthal variations), a programmable delay is used in conjunction with the amplitude detector to provide an array of measurements at different angular positions along the track with respect to some fixed index. For a given array of measurements, the principles of finding the value of the coercive force remain the same. Additionally, one can repeat the measurement at different radial locations 60, thereby obtaining a surface map of coercivity variations over the disc surface.

A known disc member with a thickness of 4.0 microinches (determined by X-ray fluorescence analysis) and a known coercive force of 620 Oe as determined by a calibrated Vibrating Sample Magnetometer was utilized as the standard disc. The standard read/write head consisted of a MnZn Ferrite head with a gap length of 40 microinches, track width of 0.72 mils, a flying height of 19.4 microinches at a disc radius of 1.8 inches (5-1/4" disc) and with 19 turns bifilar. The signal amplitude was then plotted as a function of the DC erase current and/or the head field as shown in FIG 5. The DC erase current value at the -6dB signal level equivalent to the coercive force was then determined to be 6.3 milliamperes in this case. Therefore, the value of $a_w$ in Equation 6 is calculated as:

$$a_w = \frac{40\ (2.54)\ (620)\ 10^{-6}}{19\ (0.8)(0.0063)\arctan[40/2(19.4 + 2)]}$$

$a_w = 0.877$

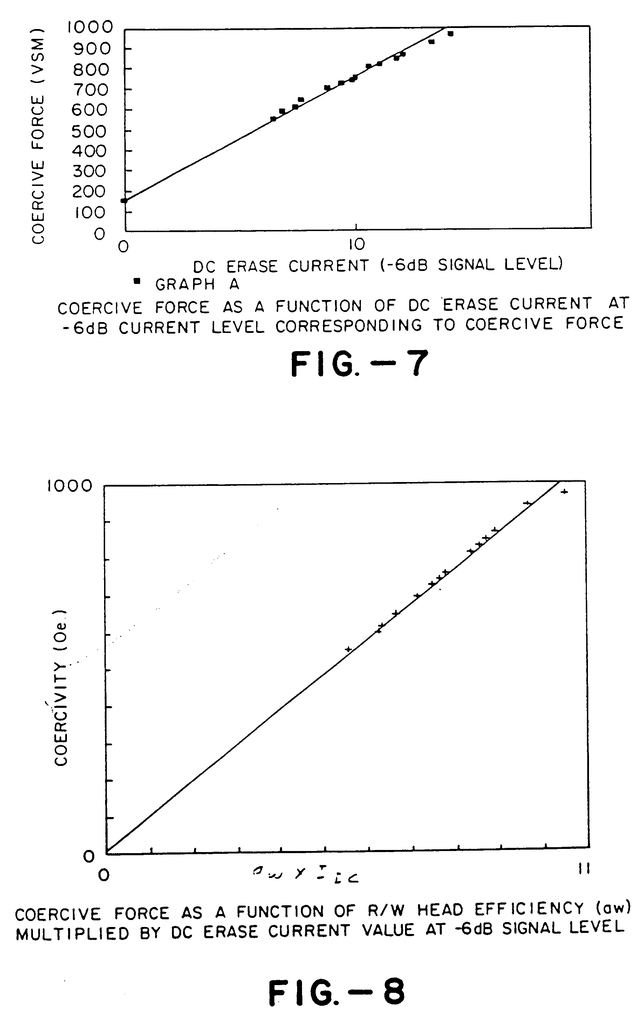

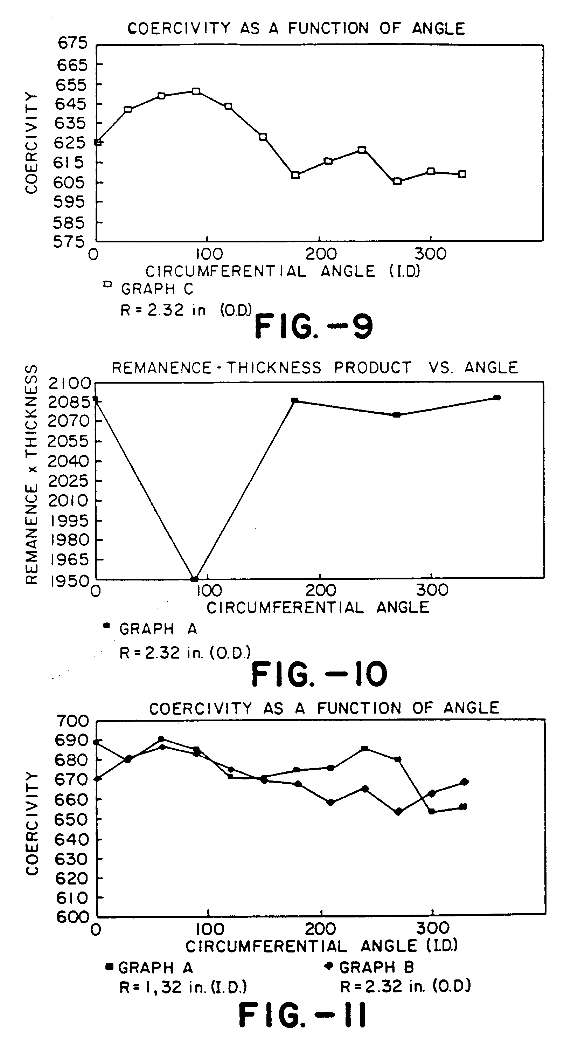

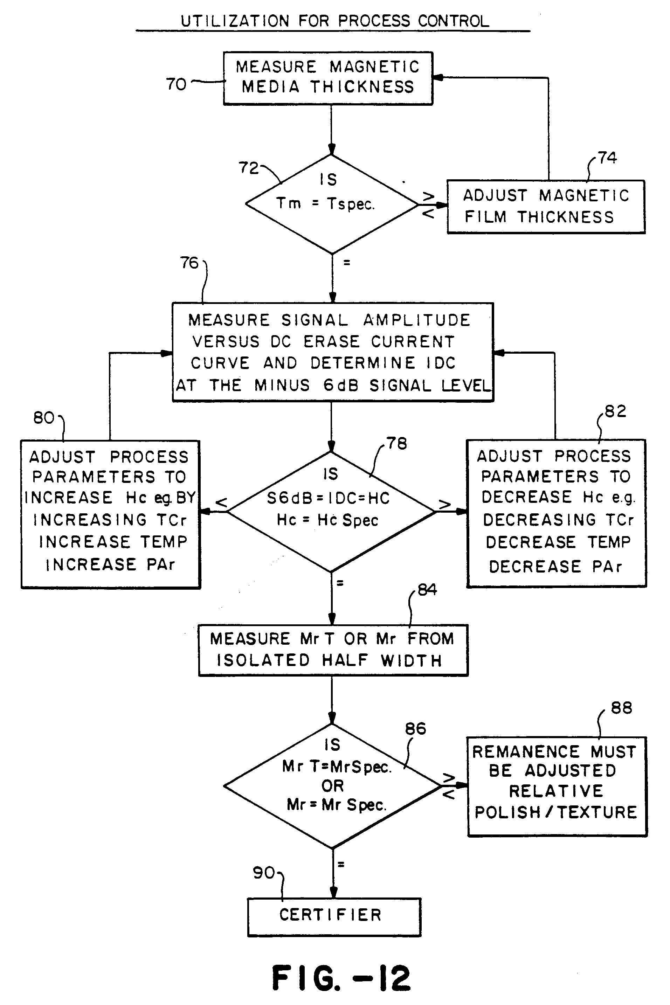

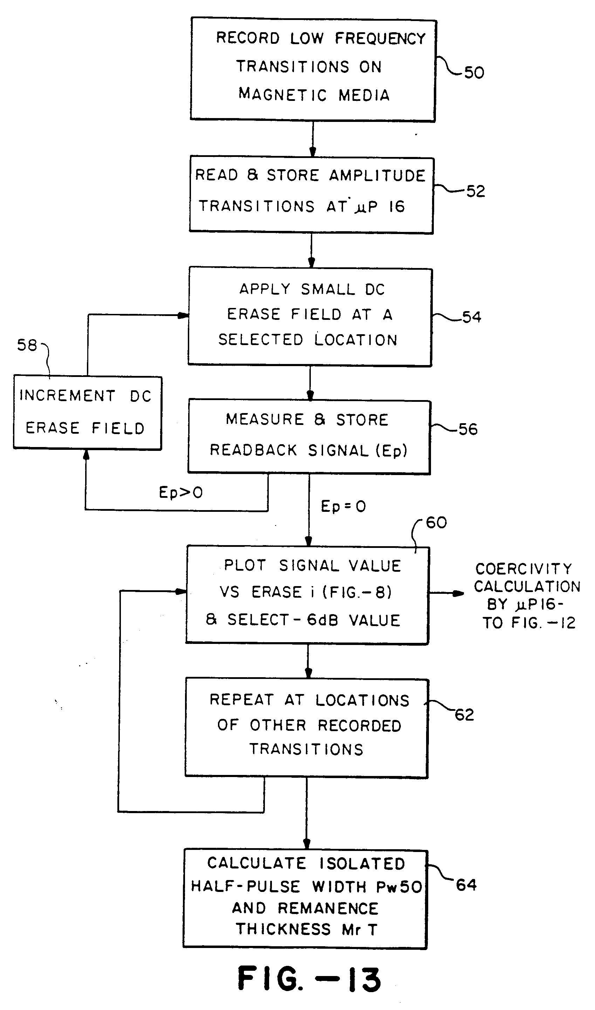

It should be noted that R/W head efficiency $a_w$ during erasure is a function of the DC erase current magnitude when using a 40 microinch gap R/W head. This was determined by utilizing standard discs with known increasing coercive force values, namely from 550 Oe to 967 Oe (Vibrating Sample Magnetometer). The results are shown in FIG 6. Consequently, when plotting the coercive force vs. the DC erase current at the zero DC erase current value, a coercive force value remains as shown in FIG 7. This is believed to be due to a non-linear variation in the head core permeability as a function of the write current and/or partial gap saturation at greater DC erase currents. This effect may be eliminated or minimized upon utilization of

EP 0 297 922 B1

a large gap R/W head. Therefore, in order to determine accurate values of the coercive force when using a small gap head such as 40 microinches it is desirable to determine the DC erase current (-6dB signal) and evaluate the efficiency $a_w$ for that particular DC erase current value. The coercive force for that particular DC erase current may then be determined from FIG 8, where the coercive force versus the write current times efficiency is plotted which is linear and passes through zero coercive force at zero DC erase current. However, in general for a 40 microinch R/W head an efficiency of 0.877 was utilized in the following examples:

1. Evaluation of Coercive Force:

The coercive force of an unknown disc media as a function of circumference (30 degree intervals around the outside track radius) was determined from the -6dB signal level current value using Equation 6 with an $a_w$ value of 0.877. The R/W gap length was $40^\mu$ in (N-19 turns bifilar).

| Angle | Current (-6dB Signal) | Coercive Force |
|---|---|---|
| 0 | 6.36 ma | 625 |
| 30 | 6.52 | 642 |
| 60 | 6.60 | 649 |
| 90 | 6.62 | 651 |
| 120 | 6.54 | 643 |
| 150 | 6.385 | 628 |
| 180 | 6.18 | 608 |
| 210 | 6.265 | 615 |
| 240 | 6.31 | 621 |
| 270 | 6.145 | 605 |
| 300 | 6.20 | 610 |
| 330 | 6.195 | 609 |

The mean coercive force around the track was 625.5 Oe. The maximum coercive force was 651 Oe, whereas the lowest coercive force was 605 Oe. The coercivity range was 46 Oe and the standard deviation was 18 Oe. The coercive force as a function of angle is shown in FIG 9.

2. Evaluation of the Remanence-Thickness Product:

The isolated half pulse width, Pw50, (freq = 500 KHz) of the signal amplitude was then determined as a function of the circumference (90 degree intervals around the outside track radius) and the remanence-thickness product, Mr, was measured 64 utilizing Equation 13 in conjunction with the coercive force as a function of angle as shown above. The results are shown below:

| Angle | Pw50 (microinches) | MrT (emu/cc microinch) |
|---|---|---|
| 0 | 83.6 | 2088 |
| 90 | 82.0 | 1951 |
| 180 | 84.0 | 2085 |
| 270 | 84.0 | 2074.8 |

Consequently, the mean remanence-thickness product of the media was 2049.7 emu/cc microinch or 2.57 microinch Tesla ($2049.7 \times 4 \times 10^{-6}$). A graph or display of the remanence-thickness product as a function of angle is shown in FIG 10.

3. Evaluation of the Coercive Force:

The coercive force of an unknown disc media as a function of circumference (30 degree intervals) on the outside track radius (r = 2.32") and the inside track radius (r = 1.32") was determined utilizing a R/W head with a gap of 40 microinches flying at the outside track radius at 23 microinches and 16 microinches on the inside track radius. The number of turns was 19 bifilar. The coercive force was determined on the basis of Equation 6 as illustrated in Example 1; i.e., utilizing an $a_w$ value of 0.877. The results are shown in the table below where $I_{DC}$ is the DC erase current in milliamperes (at the -6dB signal level) and Hc is the corresponding coercive force value.

| Angle | $I$DC (OD) | Hc (OD) | $I$DC (ID) | Hc (ID) |
|-------|-----------|---------|-----------|---------|
| 0 | 8.193 | 672 | 6.693 | 669 |
| 30 | 8.307 | 682 | 6.808 | 680 |
| 60 | 8.396 | 687 | 6.919 | 691 |
| 90 | 8.327 | 684 | 6.862 | 685 |
| 120 | 8.219 | 675 | 6.732 | 672 |
| 150 | 8.169 | 670 | 6.720 | 671 |
| 180 | 8.112 | 666 | 6.757 | 675 |
| 210 | 8.034 | 659 | 6.771 | 676 |
| 240 | 8.11 | 666 | 6.872 | 686 |
| 270 | 7.964 | 654 | 6.804 | 680 |
| 300 | 8.069 | 663 | 6.842 | 684 |
| 330 | 8.136 | 668 | 6.570 | 656 |

Consequently, the mean coercivity at the inside track radius was 677 Oe, the maximum coercive force was 691 Oe and the minimum coercive force was 656 Oe (a range of 35 Oe). These results are shown in FIG 11.

The calculated values are especially useful in modifying the manufacturing process for magnetic discs. Currently, manufacturing must rely on the recording performance to monitor progress and/or adjust signal process parameters to conform to recording specifications in the absence of destructive testing such as provided by the known test systems. Typically, if recording performance is used, the signal amplitude at high frequency is utilized to adjust manufacturing process parameters. However, signal amplitudes at high frequencies are a complex function of remanence (Mr), coercive force (Hc), and thickness of the magnetic media (T). Therefore, the question becomes whether to adjust Mr (polishing), Hc (Cr thickness), temperature, etc. or T (time power). The thickness can be conveniently monitored by X-ray fluorescence; but, to determine whether to adjust Mr or Hc, additional information is required which specifies Hc independently of Mr.

Two additional recording parameters which should be determined and which aid in the monitoring of the disc development process are the isolated signal half pulse width (Pw50) and the optimum write current (Iw).

The calculation of these values have been shown above. The optimum write current(predetermined at minimum write current for maximum 2f signal amplitude) is independent of Mr and directly dependent on Hc and indirectly on T for a given read/write head and spacing. Consequently, variation in Iw corresponds to a variation of Hc for a known thickness. If the value of Iw is constant but Pw50 varies, then only Mr need be modified. Therefore, by monitoring and comparing signal amplitude, Pw50, Iw, and thickness, it can be determined whether Mr or Hc require adjusting.

A procedure for evaluation and estimation of the magnetic properties and making the necessary adjustments to optimize a sputtered disc output is shown in FIG 12. The monitoring process first measures in this case the Co-Cr magnetic thickness 70. To the extent there is a variation from specification 72, the thickness (generally by deposition time) may be adjusted 74. If the thickness specification is met, then the minus 6 dB Signal amplitude is determined at a specific DC erase current I DC 76 which then allows determination of the coercive force. If Hc is less than or greater than Hc spec., then adjust process parameters 80, 82. If the coercive force meets specification 78, the Isolated Half Pulse Width is measured 84. From the Isolated Half Pulse Width (PW 50) the remanence-thickness product (MrT) may be determined or Mr may be determined since the thickness is known. If the MrT product or Mr is greater or less than specification 86, then the remanence or Mr has changed and the polish/texture of the disc surface must be re-evaluated 88. If the MrT product or Mr meets specification, then the sputtering system or disc process is satisfactory and discs are then certified 90.

With these adjustments in the process, a consistent output without destructive testing of the magnetic recording media can be achieved. Consistent testing of large numbers of the magnetic discs can be achieved as well.

A greater gap length R/W head may be used to measure the coercive force distribution and/or remanence-thickness product of the recording member.

**Claims**

1. A method of measuring coercivity in a magnetic storage disc medium (6), for use with a magnetic storage device including a rotatable magnetic storage disc medium (6) having a plurality of data recording tracks thereon to define data recording locations, and a read/write head (8) selectively positionable over said data recording locations, said measuring method comprising the steps of (50) recording signals in a plurality of said data recording locations on said disc (6), (54) applying a DC erase field sufficient to erase the recorded signal at one of said recording locations by 50% (6 db) relative to an unerased state of said recorded signal, (56, 60) measuring the magnitude of the DC erase field required to reduce the recorded signal at said one recording location by said 50% (6 db), and (64) calculating the coercivity of the disc (6) according to the magnitude of the DC erase field required to produce said 50% (6 db) reduction in said recorded signal.

2. A method as claimed in Claim 1 wherein the coercivity Hx is calculated as a function of the relationship

$$H_x = \frac{0.8NiAw}{g \; arctan \; (g/2y)}$$

where i is the current in amperes passed through said read/write head (8) to erase said recorded data by 50% (6 db);
   N is the number of turns on said head;
   g is the length of a gap (2) in said head used to record said data;
   Aw is the efficiency of said read/write head (8);
   y is the distance below the head at which an effective coercive force is to be measured; and
   Hx is the coercive field in oersteds.

3. A method as claimed in Claim 2 wherein y is selected to be the sum of the distance from the head (8) to the surface of the disc (6) plus 1/2 of the thickness of the disc (6).

4. A method as claimed in Claim 2 wherein the remanence-thickness product of said rotatable magnetic storage medium (6), for a given velocity of said medium relative to said head, is obtained by measuring the maximum amplitude of an isolated pulse, by measuring the half-pulse width of said pulse, and by forming the product of said maximum amplitude and said width, wherein said product approximates the integrated area under said isolated pulse.

5. A method as claimed in any of Claims 2 to 4 including the steps of (50, 62) positioning said head (8) over said data recording location on said disc (6),
   (56) measuring a field induced in said head (8) by polarizing magnetic domains in said disc (6) representing the data stored at said location,
   (56) storing said measured induced field as an initial field,
   (58) carrying out said steps of (54) applying a DC erase field and (56) measuring the induced signal until the measured induced signal is one-half said initial signal, the coercive force Hx being the applied erase field necessary to carry out the one-half reduction in said signal amplitude.

6. A method as claimed in Claim 5 including the steps of (58) applying said DC erase field in measurably increased levels,
   (56) measuring and storing the readback signal to said head,
   (58) increasing said DC erase field until said readback signal is substantially 50% of the initial amplitude.

7. A method as claimed in Claim 6 wherein said increments (58) of change in the DC erase field are about 50 oersteds.

8. A method as claimed in Claim 7 including the step of interpolating between data points bracketing said 50% readback level, whereby a resolution of much less than 50 oersteds is achieved.

**9.** A method as claimed in Claim 6 including carrying out the steps leading to detection of said 50% amplitude reduction at a plurality of said data recording locations on said disc (6).

**10.** A system for determining magnetic characteristics of a magnetic medium (6) member at various known coordinate positions of the medium (6) characterized in that it comprises

means for applying a write current through a gap (2) of a recording head (8) for recording a sequence of isolated magnetic transitions at said known coordinate positions, a means for applying a DC erase field by sourcing an amount of current through said head as determined by the relationship

$$H_x = \frac{0.8\ N\ I\ a_w}{g}\ arctan\ \frac{g}{2y}$$

wherein y is the known head-medium (d) spacing, g is the known gap (2) width, I is the measured applied current required to produce said DC erase field, N is the known number of turns on the head, and $a_w$ is a known calibration constant dependent on head geometry; a means (12,13) for measuring a resulting readback signal, (58) means for increasing the applied field by incremental amounts, and means for plotting the relationship of said signal read-back and applied field,

whereby a point representing 50% loss in signal value defines coercivity of said medium (6).

**11.** A system as claimed in Claim 10 including means responsive to said plotting means for selecting a DC erase current corresponding to a -6 dB value of said readback signal relative to an unerased state of said recorded signal, and means for calculating coercive force based on said readback signal.

**12.** A system as claimed in Claim 10 or Claim 11 including means for operating on characteristics of an isolated pulse signal to calculate the remanence-thickness product of the magnetic medium (6).

**13.** A method as claimed in any of Claims 10 to 12, wherein said calibration constant $a_w$ is determined by the following steps:

determining for a calibration rotatable magnetic storage medium the magnitude of current I required for said read/write head to produce a DC erase field reducing said recorded signal by 50% (6 db) relative to an unerased state;

measuring coercivity $H_c$ for said calibration rotatable magnetic storage medium using a magnetometer;

calculating the efficiency $a_w$ for said read/write head according to the relationship:

$$a_w = \frac{g\ Hc}{0.8\ N\ I\ arctan\ \frac{g}{2y}}$$

wherein g, $H_c$, N, I and y are known.

**Patentansprüche**

**1.** Verfahren zum Messen der Koerzitivkraft in einem Magnetspeicherplattenmedium (6) zur Verwendung mit einer Magnetspeichereinrichtung, die ein drehbares Magnetspeicherplattenmedium (6) umfaßt, das mehrere Datenaufzeichnungsspuren zum Definieren der Datenaufzeichnungsplätze aufweist, und einen Lese/Schreib-Kopf (8), der selektiv über den Datenaufzeichnungsplätzen angeordnet werden kann, wobei das Meßverfahren die folgenden Schritte umfaßt:

(50) Aufzeichnen von Signalen in mehreren Datenaufzeichnungsplätzen auf der Platte (6),

(54) Anlegen eines Gleichstrom-Löschfeldes, das ausreicht, das aufgezeichnete Signal an einem der Aufzeichnungsplätze um 50 % (6 dB) relativ zu einem ungelöschten Zustand des aufgezeichneten Signals zu löschen,

(56, 60) Messen der Größe des Gleichstrom-Löschfeldes, das erforderlich ist, um das aufgezeichnete Signal an dem einen Aufzeichnungsplatz um 50 % (6 dB) zu reduzieren, und

(64) Berechnen der Koerzitivkraft der Platte (6) entsprechend der Größe des Gleichstrom-Löschfeldes, das erforderlich ist, um die Reduzierung um 50 % (6 dB) in dem aufgezeichneten Signal zu erzeugen.

2. Verfahren nach Anspruch 1, wobei die Koerzitivkraft Hx berechnet wird als Funktion aus der Beziehung

$$Hx = \frac{0,8NiAw}{g\,arctg(g/2y)},$$

wobei i der durch den Lese/Schreib-Kopf (8) zur Löschung der aufgezeichneten Daten um 50 % (6 dB) fließende Strom in Ampere, N die Anzahl der Windungen auf dem Kopf, g die Breite des Spalts (2) in dem für die Aufzeichnung der Daten verwendeten Kopf, Aw der Wirkungsgrad des Lese/Schreib-Kopfes (8), y der Abstand unter dem Kopf, an dem die Koerzitivkraft gemessen wird, und Hx die Koerzitivfeldstärke in Oersted sind.

3. Verfahren nach Anspruch 2, wobei y gewählt wird als Summe des Abstands vom Kopf (8) bis zur Oberfläche der Platte (6) plus 1/2 der Dicke der Platte (6).

4. Verfahren nach Anspruch 2, wobei das Remanenz-Dicke-Produkt des drehbaren Magnetspeichermediums (6) für eine gegebene Geschwindigkeit des Mediums relativ zum Kopf erhalten wird durch Messen der maximalen Amplitude eines isolierten Impulses, Messen der Halbimpulsbreite des Impulses und Bilden des Produkts aus der maximalen Amplitude und der Breite, wobei das Produkt annähernd gleich der integrierten Fläche unter dem isolierten Impuls ist.

5. Verfahren nach einem der Ansprüche 2 bis 4 mit den folgenden Schritten:
(50, 62) Anordnen des Kopfes (8) über dem Datenaufzeichnungsplatz auf der Platte (6),
(56) Messen eines in dem Kopf (8) durch Polarisieren von Magnetbereichen in der Platte (6) induzierten Feldes, wobei die Bereiche die an dem Aufzeichnungsplatz gespeicherten Daten darstellen,
(56) Speichern des gemessenen induzierten Feldes als Ausgangsfeld,
(58) Durchführen der Schritte: (54) Anlegen eines Gleichstrom-Löschfeldes und (56) Messen des induzierten Signals, bis das gemessene induzierte Signal die Hälfte des Ausgangssignals beträgt, wobei die Koerzitivkraft Hx das angelegte Löschfeld ist, das notwendig ist, um die Reduzierung um die Hälfte in der Signalamplitude durchzuführen.

6. Verfahren nach Anspruch 5 mit den Schritten:
(58) Anlegen des Gleichstrom-Löschfeldes in meßbar erhöhten Stufen,
(56) Messen und Speichern des Rückübertragungssignals zum Kopf,
(58) Erhöhen des Gleichstrom-Löschfeldes, bis das Rückübertragungssignal etwa 50 % der Ausgangsamplitude beträgt.

7. Verfahren nach Anspruch 6, wobei die Änderungserhöhungen (58) in dem Gleichstrom-Löschfeld etwa 50 Oersted betragen.

8. Verfahren nach Anspruch 7 mit dem Schritt: Interpolieren zwischen Datenpunkten, die die 50 %-Rückübertragungsstufe überbrücken, wobei eine Auflösung von weit weniger als 50 Oersted erreicht wird.

9. Verfahren nach Anspruch 6 mit Durchführung der Schritte, die zum Erfassen der Reduzierung der Amplitude um 50 % an mehreren Datenaufzeichnungsplätzen auf der Platte (6) führen.

10. System zur Bestimmung der magnetischen Eigenschaften eines Teils eines Magnetmediums (6) an verschiedenen bekannten Koordinationsstellen des Mediums (6), gekennzeichnet durch:
eine Einrichtung zum Anlegen eines Schreibstroms durch einen Spalt (2) eines Aufzeichnungskopfes (8) zur Aufzeichnung einer Folge von isolierten Magnetübergängen an den bekannten Koordinationsstellen,
eine Einrichtung zum Anlegen eines Gleichstrom-Löschfeldes durch das Fließen einer Strommenge durch den Kopf, wie bestimmt durch die Beziehung

EP 0 297 922 B1

$$Hx = \frac{0,8NIaw}{g} arctg\frac{g}{2y},$$

wobei y der bekannte Kopf-Medium-Abstand (d), g die bekannte Spaltbreite (2), I der gemessene angelegte Strom, der erforderlich ist, um das Gleichstrom-Löschfeld zu erzeugen, N die bekannte Anzahl der Windungen auf dem Kopf, und aw eine bekannte, von der Geometrie des Kopfes abhängige Kalibrierungskonstante sind;

eine Einrichtung (12, 13) zum Messen eines erfolgenden Rückübertragungssignals,

(58) eine Einrichtung zur Erhöhung des angelegten Feldes durch inkrementelle Mengen und

eine Einrichtung zur Darstellung der Beziehung der Signal-Rückübertragung und des angelegten Feldes,

wobei ein einen Signalwert-Verlust von 50 % darstellender Punkt die Koerzitivkraft des Mediums (6) definiert.

11. System nach Anspruch 10 mit einer Einrichtung, die auf die Darstellungseinrichtung anspricht zur Auswahl eines Lösch-Gleichstromes entsprechend einem -6 dB Wert des Rückübertragungssignals relativ zu einem ungelöschten Zustand des aufgezeichneten Signals, und einer Einrichtung zur Berechnung der Koerzitivkraft auf der Grundlage des Rückübertragungssignals.

12. System nach Anspruch 10 oder 11 mit einer Einrichtung zur Verarbeitung von Merkmalen eines isolierten Impulssignals zur Berechnung des Remanenz-Dicke-Produkts des Magnetmediums (6).

13. Verfahren nach einem der Ansprüche 10 bis 12, wobei die Kalibrierungskonstante aw bestimmt wird durch die folgenden Schritte:

Bestimmen der Größe des Stromes I, der für den Lese/Schreib-Kopf erforderlich ist, um ein Gleichstrom-Löschfeld zu erzeugen, das das aufgezeichnete Signal um 50 % (6 dB) relativ zu einem ungelöschten Zustand verringert, für ein drehbares Kalibrierungs-Magnetspeichermedium;

Messen der Koerzitivkraft Hc für das drehbare Kalibrierungs-Magnetspeichermedium, bei dem ein Magnetometer verwendet wird;

Berechnen des Wirkungsgrads aw für den Lese/Schreib-Kopf entsprechend der Beziehung

$$aw = \frac{gHc}{0,8NIarctg\frac{g}{2y}},$$

wobei g, Hc, N, I und y bekannt sind.

**Revendications**

1. Un procédé de mesure de coercivité dans un disque d'enregistrement magnétique (6), prévu pour l'utilisation avec un dispositif d'enregistrement magnétique comprenant un disque d'enregistrement magnétique tournant (6) sur lequel sont formées un ensemble de pistes d'enregistrement de données, pour définir des positions d'enregistrement de données, et une tête de lecture/écriture (8) qui peut être positionnée sélectivement sur les positions d'enregistrement de données, ce procédé de mesure comprenant les étapes suivantes : (50) on enregistre des signaux dans un ensemble des positions d'enregistrement de données sur le disque (6); (54) on applique un champ d'effacement continu suffisant pour réduire de 50% (6 dB) le signal enregistré à l'une des positions d'enregistrement, par rapport à un état non effacé du signal enregistré, (56, 60) on mesure le niveau du champ d'effacement continu qui est nécessaire pour réduire de 50% (6 dB) le signal enregistré à la position d'enregistrement considérée, et (64) on calcule la coercivité du disque (6) conformément au niveau du champ d'effacement continu qui est nécessaire pour produire la réduction de 50% (6 dB) du signal enregistré.

**2.** Un procédé selon la revendication 1, dans lequel on calcule la coercivité Hx par la relation :

$$H_x = \frac{0,8NiAw}{g \arctan (g/2y)}$$

dans laquelle i est le courant en ampères que l'on doit faire passer dans la tête de lecture/écriture (8) pour réduire de 50% (6 dB) les données enregistrées;

N est le nombre de spires de la tête;

g est la longueur d'un entrefer (2) dans la tête qui est utilisée pour enregistrer les données;

Aw est le rendement de la tête de lecture/écriture (8);

y est la distance au-dessous de la tête à laquelle on doit mesurer une force coercitive effective; et

Hx est le champ coercitif en oersteds.

**3.** Un procédé selon la revendication 2, dans lequel on prend y égal à la somme de la distance de la tête (8) jusqu'à la surface du disque (6), et de la moitié de l'épaisseur du disque (6).

**4.** Un procédé selon la revendication 2, dans lequel on obtient le produit rémanence-épaisseur du disque d'enregistrement magnétique tournant (6), pour une vitesse donnée du disque par rapport à la tête, en mesurant l'amplitude maximale d'une impulsion isolée, en mesurant la largeur à mi-hauteur de cette impulsion, et en formant le produit de l'amplitude maximale et de la largeur, ce produit constituant une approximation de l'aire intégrée sous l'impulsion isolée.

**5.** Un procédé selon l'une quelconque des revendications 2 à 4, comprenant les étapes suivantes : (50, 62) on positionne la tête (8) sur la position d'enregistrement de données sur le disque (6),

(56) on mesure un champ qui est induit dans la tête (8) en polarisant des domaines magnétiques dans le disque (6) représentant les données enregistrées à cette position,

(56) on enregistre le champ induit mesuré, à titre de champ initial,

(58) on accomplit les étapes d'application d'un champ d'effacement continu (54) et de mesure du signal induit (56), jusqu'à ce que le signal induit mesuré soit égal à la moitié du signal initial, la force coercitive Hx étant le champ d'effacement appliqué qui est nécessaire pour produire la réduction de moitié de l'amplitude du signal.

**6.** Un procédé selon la revendication 5, comprenant les étapes suivantes : (58) on applique le champ d'effacement continu par niveaux accrus de façon mesurable,

(56) on mesure et on enregistre le signal de relecture qui est appliqué à la tête,

(58) on augmente le champ d'effacement continu jusqu'à ce que le signal de relecture soit pratiquement égal à 50% de l'amplitude initiale.

**7.** Un procédé selon la revendication 6, dans lequel les incréments (58) de changement du champ d'effacement continu sont d'environ 50 oersteds.

**8.** Un procédé selon la revendication 7, comprenant l'étape d'interpolation entre des points de données qui encadrent le niveau de relecture de 50%, grâce à quoi on obtient une résolution bien meilleure que 50 oersteds.

**9.** Un procédé selon la revendication 6, comprenant l'accomplissement des étapes qui conduisent à la détection de la réduction d'amplitude de 50%, à un ensemble des positions d'enregistrement de données sur le disque (6).

**10.** Un système de détermination de caractéristiques magnétiques d'un élément magnétique (6) à diverses positions de coordonnées connues de l'élément (6), caractérisé en ce qu'il comprend :

des moyens pour appliquer un courant d'écriture à un entrefer (2) d'une tête d'enregistrement (8), pour enregistrer une séquence de transitions magnétiques isolées aux positions de coordonnées connues, des moyens pour appliquer un champ d'effacement continu en appliquant à la tête une valeur de courant qui est déterminée par la relation :

$$H_x = \frac{0{,}8\ N\ I\ a_w}{g}\ \text{arctan}\ \frac{g}{2y}$$

dans laquelle y est l'écartement tête-élément (d) connu, g est la largeur connue de l'entrefer (2), I est le courant appliqué mesuré qui est nécessaire pour produire le champ d'effacement continu, N est le nombre de spires sur la tête, qui est connu, et $a_w$ est une constante d'étalonnage connue qui dépend de la configuration géométrique de la tête; des moyens (12, 13) pour mesurer un signal de relecture résultant, des moyens (58) pour augmenter de valeurs incrémentielles le champ appliqué, et des moyens pour représenter graphiquement la relation entre le signal de relecture et le champ appliqué,

grâce à quoi un point représentant 50% d'atténuation de la valeur de signal définit la coercivité de l'élément (6).

11. Un système selon la revendication 10, comprenant des moyens qui fonctionnent sous la dépendance des moyens de représentation graphique, de façon à sélectionner un courant d'effacement continu correspondant à une valeur de -6 dB du signal de relecture, par rapport à un état non effacé du signal enregistré, et des moyens pour calculer la force coercitive sur la base du signal de relecture.

12. Un système selon la revendication 10 ou la revendication 11, comprenant des moyens qui sont destinés à travailler sur des caractéristiques d'un signal d'impulsion isolée pour calculer le produit rémanence-épaisseur de l'élément magnétique (6).

13. Un procédé selon l'une quelconque des revendications 10 à 12, dans lequel la constante d'étalonnage $a_w$ est déterminée par les étapes suivantes :

on détermine pour un élément d'enregistrement magnétique tournant d'étalonnage l'intensité du courant I qui est nécessaire pour que la tête de lecture/écriture produise un champ d'effacement continu réduisant le signal enregistré de 50% (6 dB) par rapport à un état non effacé;

on mesure la coercivité $H_c$ pour cet élément d'enregistrement magnétique tournant d'étalonnage, en utilisant un magnétomètre;

on calcule le rendement $a_w$ de la tête de lecture/écriture conformément à la relation :

$$a_w = \frac{g\ H_c}{0{,}8\ N\ I\ \text{arctan}\ \frac{g}{2y}}$$

dans laquelle g, $H_c$, N, I et y sont connus.

TYPICAL HYSTERESIS LOOP OF A MAGNETIC MATERIAL
INDICATING SATURATION MAGNETIZATION (Ms), REMANENCE (Mr)
AND COERCIVE FORCE (Hc)

# FIG.-1

TYPICAL HEAD-MEDIA INTERFACE CONFIGURATION

# FIG.-2

16

FIG. -3

FIG. -4

17

CALIBRATION CURVE

FIG. - 5

R/W HEAD ERASE EFFICIENCY AS A FUNCTION OF
DC ERASE CURRENT AT THE -6 dB SIGNAL VALUE

FIG. - 6

18

GRAPH A
COERCIVE FORCE AS A FUNCTION OF DC ERASE CURRENT AT
-6dB CURRENT LEVEL CORRESPONDING TO COERCIVE FORCE

# FIG. — 7

COERCIVE FORCE AS A FUNCTION OF R/W HEAD EFFICIENCY (σw)
MULTIPLIED BY DC ERASE CURRENT VALUE AT -6dB SIGNAL LEVEL

# FIG. — 8

COERCIVITY AS A FUNCTION OF ANGLE

GRAPH C
R = 2.32 in. (O.D.)

FIG. −9

REMANENCE - THICKNESS PRODUCT VS. ANGLE

GRAPH A
R = 2.32 in. (O.D.)

FIG. −10

COERCIVITY AS A FUNCTION OF ANGLE

GRAPH A          GRAPH B
R = 1,32 in. (I.D.)       R = 2.32 in. (O.D.)

FIG. −11

UTILIZATION FOR PROCESS CONTROL

FIG. –12

RECORD LOW FREQUENCY
TRANSITIONS ON
MAGNETIC MEDIA — 50

READ & STORE AMPLITUDE
TRANSITIONS AT μP 16 — 52

APPLY SMALL DC
ERASE FIELD AT A
SELECTED LOCATION — 54

58 — INCREMENT DC
ERASE FIELD

MEASURE & STORE
READBACK SIGNAL (Ep) — 56

Ep > 0

Ep = 0

60

PLOT SIGNAL VALUE
VS ERASE i (FIG.—8)
& SELECT — 6dB VALUE

COERCIVITY
CALCULATION
BY μP16-
TO FIG. —12

REPEAT AT LOCATIONS
OF OTHER RECORDED
TRANSITIONS — 62

CALCULATE ISOLATED
HALF-PULSE WIDTH Pw50
AND REMANENCE
THICKNESS Mr T — 64

# FIG. —13